# EUROPEAN PATENT APPLICATION

(11) **EP 4 257 948 A1**
(43) Date of publication of application: **11.10.2023**
(21) Application number: 22166523.5
(22) Date of filing: 04.04.2022
(51) Int. Cl.: G01N 1/02

(54) **METHOD AND SYSTEM FOR INSPECTING A SURFACE**

(71) Applicant: Nederlandse Organisatie voor toegepast-natuurwetenschappelijk Onderzoek TNO, 2595 DA 's-Gravenhage (NL)
(72) Inventor: DE JONG, Antonius Martinus Cornelis Petrus, 2595 DA 's-Gravenhage (NL); OOSTROM, Sjoerd, 2595 DA 's-Gravenhage (NL)
(74) Representative: V.O.

(57) **Abstract**

A method and system (100) for inspecting a surface (Ss). A lighting device (10) is configured to provide a light beam (Lp) focused at a focal point (Lf) at a distance (Df) from a surface (Ss) to cause a shockwave (W) reaching the surface (Ss) for dislodging particles (Ps) from the surface (Ss) and causing the particles (Ps) dislodged from the surface (Ss) to become airborne particles (Pa). A particle detector (20) is configured to detect the airborne particles (Pa) dislodged by the shockwave (W) from the surface (Ss). For example, this can be used for quantifying a cleanliness and/or contamination of the surface (Ss) by surface-bound nanoparticles (Ps), which were at least present on the surface (Ss) prior to the shockwave (W), based on a detected amount of the airborne particles (Pa), after the shockwave (W) is applied.

## Description

### TECHNICAL FIELD AND BACKGROUND

The present disclosure relates to methods and systems for inspecting a surface, in particular for determining cleanliness of the surface and/or determining particles contaminating the surface.

In various fields such, as the semiconductor industry, there is a need for cleanliness of products and equipment. For example, contamination by particles may directly impact the yield of chip production. Since the feature size of chips are shrinking to (below) the ten nanometer range, there is a corresponding need to effectively determine cleanliness and/or contamination of various surfaces by particles on nanometer scales.

As background, US5023424A describes an apparatus and method using laser induced shock waves to dislodge particles from a wafer surface. The apparatus includes a wafer support, a particle detector and computer for locating and storing the locations of particles on the wafer, two lasers, and focusing optics. The particle detector includes a first laser generating a narrow beam and a scanning mirror for sweeping the beam in a path across the wafer surface via a slot. Light scattered from particles on the wafer at a first focus is specularly reflected via a light collector and detected. As described, the particle detector is used to locate a position of each particle on the wafer surface. Then a shock wave is produced by a beam pulse of a second laser proximate to one such located position to remove nearby particles. To avoid damage to the wafer, the laser beam pulses are directed toward the wafer surface at a shallow angle or with a large beam convergence angle. While the known method of detecting particles by measuring scattered light from the substrate may be suitable for relatively large particles, e.g. more than one micron, the suitability may diminish for smaller particles, e.g. less than hundred nanometer, whereas the detection of such small particles is becoming increasingly important for the current scales (<10nm) used in the semiconductor industry. Also the known optical detection technique may not be suitable to measure rough surfaces, e.g. comprising 3D product surfaces with out-of-plane features that can lead to a false reading.

As further background, US 10,712,355 B2 describes a high resolution surface particle detector. A particle counting device includes a scanner probe having a first opening for receiving particles from a sample surface and second openings. Pumps produce a first airstream flowing from the first opening and a second airstream flowing to the second openings. A flow device splits the first airstream into third and fourth airstreams. A first particle detector detects particles in the third airstream. The first particle detector is capable of detecting particles within a first range of particle sizes. A second particle detector detects particles in the fourth airstream. The second particle detector is capable of detecting particles within a second range of particle sizes different from the first range of particle sizes. The high resolution detector preferably includes a flow sensor which measures the flow rate of the airstream through detector, and provides its output signal to the controller. The airstream exiting the flow sensor passes through a detector, which detects and measures the number of particles in the airstream. Preferably, the detector includes a pump to assist in the flow of the airstream through detector. The pump is operated under the control of the controller to maintain the proper flow rate of the airstream. The airstream exiting pump passes through an optional filter, and then is discharged from the unit through an output port. One example of the high resolution detector is a condensation particle counter (CPC), which includes a special fluid and a laser optics sensor. The special liquid, which can be water or alcohol based, is vaporized and condenses on any particles in the airstream, which "grows" the particles to a size that can be counted with laser optics technology (i.e. the combination of the vaporized fluid particles condensed onto the particles make the combination large enough to detect using a laser optics sensor). The detector is capable of detecting/ measuring particles with sizes of 10 nm to 1000 nm. Because of its higher resolution measurement technique, it can only process a low rate of air flow (e.g. 0.1 CFM). The output signal of the high resolution detector is provided to the controller. The low resolution detector is a conventional optical detector that detects/measures the number of particles in the airstream 30. The low resolution detector is preferably a conventional optical laser based detector, and is capable of detecting/measuring particles with sizes as small as 300 nm and as large as 10,000 nm or larger. This lower resolution measurement technique can process a higher rate of air flow (e.g., 1.0 CFM). The output signal of the low resolution detector is provided to the controller

US2002083780A1 describes a surface particle detector that includes a scanner slidable over a surface, a particle counter for counting particles "Pa"ssed therethrough, and a conduit connected between the scanner and the particle counter. The particle counter includes a pump for creating an airstream for drawing particles from the surface, through the scanner and conduit, to the particle counter, and back to the scanner. A sensor measures the airstream flow rate, and a controller controls the pump speed based upon the sensed airstream flow rate. The conduit attaches to the particle counter via a first connector, which contains electronic indicia identifying the type of scanner attached to the other end of the conduit. The controller controls the particle counter in response to the detected electronic indicia. The particle counter also includes a removable filter cartridge with a filter element that captures the counted particles for laboratory analysis.

There is a need for further improved methods and systems for inspecting a surface, in particular for determining cleanliness of the surface and/or determining particles contaminating the surface.

### SUMMARY

Aspect of the present disclosure relate to methods and systems for inspecting a surface, in particular for measuring the presence and/or quantity of particles on the surface. A focused light beam is provided to produce a shockwave capable of dislodging the particles from the surface. The dislodged particles may become airborne and measured, e.g. as part of a particle flow. Accordingly, the cleanliness and/or contamination of the surface can be based on the detected airborne particles. Advantageously, (highly attached) nano particles can be removed with a laser shock wave (creating locally a high air flow) from the surface, without damaging the sensitive products, e.g. by control of the laser shock conditions. To further improve measurement sensitivity, the laser chamber/ probe can be flushed with ultra clean air which may collect the lifted nano particles. Once the nano particles are airborne, they can be easily detected with any available airborne particle detector.

The inventors have recognized that until now there are have been no reliable methods available to determine nano particle cleanliness on surfaces. For example, the known methods do not give reliable quantitative information on nano particle cleanliness (1-1000 nm range) on flat and rough surfaces. As a fundamental obstacle, the nano particle may be the same size as, or smaller than, the roughness of the surface they are on. Direct optical techniques may thus be unsuitable to detect such particles. Instead, the present solution involves first isolating the particles by lifting them from the product. Since nano particles may stick more strongly than larger micron sized particles, there is relative more force needed to lift them. Furthermore, this process is delicate because no damage or contamination may occur on the analyzed (fragile) product surface. With the present disclosed methods and systems there is no need for using chemicals, impact of water, physical contact on the surface, movement of tool parts, or high overall air flow rates, which may generally can result in extra contamination or damage to the sensitive products. In the present solution, only focused light is needed to generate, very locally, accelerated impact of clean air to dislodge nano particles to be air borne. Furthermore, the amount of force can be easily controlled by a position the focus point of the beam above the surface and/or intensity of the beam. So only clean air is 'touching" the sensitive product surface. Once nano particles are airborne, they can float (e.g. with relatively low deposition velocity) in a gentle air flow to a suited particle detector.

### BRIEF DESCRIPTION OF DRAWINGS

These and other features, aspects, and advantages of the apparatus, systems and methods of the present disclosure will become better understood from the following description, appended claims, and accompanying drawing wherein:
FIG 1 illustrates an inspection system comprising a lighting device and a particle detector;
FIG 2 illustrates an inspection system further comprising a flow source;
FIG 3 illustrates an inspection system further comprising a container with an opening placed against an inspected surface;
FIG 4 illustrates an inspection system comprising a container holding a substrate inside;
FIG 5A illustrates further aspects of an inspection system;
FIG 5B illustrates further aspects of a particle detector.

### DESCRIPTION OF EMBODIMENTS

Terminology used for describing particular embodiments is not intended to be limiting of the invention. As used herein, the singular forms "a", "an" and "the" are intended to include the plural forms as well, unless the context clearly indicates otherwise. The term "and/or" includes any and all combinations of one or more of the associated listed items. It will be understood that the terms "comprises" and/or "comprising" specify the presence of stated features but do not preclude the presence or addition of one or more other features. It will be further understood that when a particular step of a method is referred to as subsequent to another step, it can directly follow said other step or one or more intermediate steps may be carried out before carrying out the particular step, unless specified otherwise. Likewise it will be understood that when a connection between structures or components is described, this connection may be established directly or through intermediate structures or components unless specified otherwise.

The invention is described more fully hereinafter with reference to the accompanying drawings, in which embodiments of the invention are shown. In the drawings, the absolute and relative sizes of systems, components, layers, and regions may be exaggerated for clarity. Embodiments may be described with reference to schematic and/or cross-section illustrations of possibly idealized embodiments and intermediate structures of the invention. In the description and drawings, like numbers refer to like elements throughout. Relative terms as well as derivatives thereof should be construed to refer to the orientation as then described or as shown in the drawing under discussion. These relative terms are for convenience of description and do not require that the system be constructed or operated in a particular orientation unless stated otherwise.

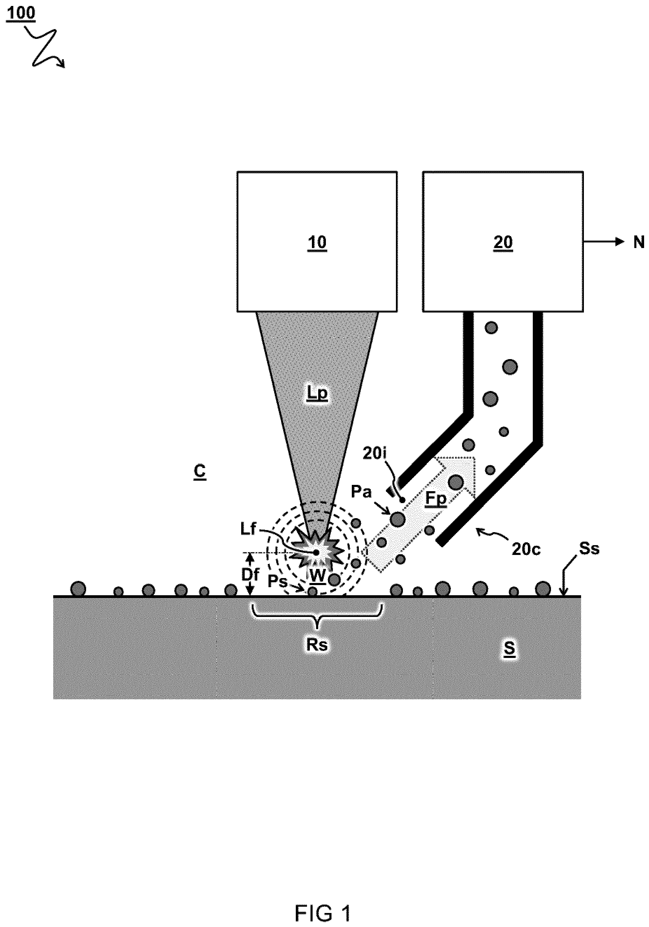

FIG 1 illustrates aspects of an inspection system 100 comprising a lighting device 10 and a particle detector 20 for inspecting a surface "Ss".

Some aspects of the present disclosure can be embodied as a method for inspecting a surface "Ss". One embodiment comprises measuring the presence and/or quantity of particles "Ps" which may be stuck on the surface "Ss". In a preferred embodiment, e.g. as shown, a light beam "Lp" is focused at a focal point "Lf". The focal point "Lf' is at a distance "Df' from the surface "Ss". The focused light beam "Lp" is configured to cause a shockwave "W" reaching the surface "Ss" for dislodging particles "Ps" from the surface "Ss". This may cause causing the particles "Ps" dislodged from the surface "Ss" to become airborne particles "Pa". In another or further preferred embodiment, the airborne particles "Pa", dislodged by the shockwave "W" from the surface "Ss", are detected while they are airborne. Other or further aspects can be embodied as a method for determining cleanliness and/or contamination of a surface "Ss" by surface-bound particles "Ps". Some embodiments comprise inspecting the surface "Ss", e.g. as described above. Other or further embodiments comprise determining the cleanliness and/or contamination of the surfaces Ss based on the detected airborne particles "Pa".

Some embodiments comprise determining a designated region "Rs" of the surface "Ss" for measuring, e.g. sampling, the cleanliness and/or possible contamination. For example, the designated region "Rs" is a local area of a substrate to be inspected for the presence of surface-bound particles "Ps". In one embodiment, a light beam "Lp" is focused at a focal point "Lf' at a distance "Df' from, e.g. above or adjacent, the designated region "Rs" to generate a plasma at the focal point "Lf' causing a shockwave "W". Preferably, the shockwave "W" is configured for dislodging at least some of the particles "Ps" possibly contaminating the surface "Ss" in the designated region "Rs". Most preferably this causes the particles "Ps" dislodged from the surface "Ss" to become airborne particles "Pa". Other or further embodiments comprise detecting the airborne particles "Pa". For example, the cleanliness and/or possible contamination can be based on the detected airborne particles "Pa", e.g. based on the absence or presence of the detected airborne particles "Pa", and/or based on the amount of the detected airborne particles "Pa".

As will be understood, aspects of the present disclosure described herein with reference to specific methods can also be embodied by corresponding systems, devices, and/or components; and vice versa. Accordingly, some aspects can be embodied as a corresponding inspection system 100. In one embodiment, the inspection system 100 comprises a lighting device 10 configured to provide a light beam "Lp" focused at a focal point "Lf' at a distance "Df' from a surface "Ss" to cause a shockwave "W" reaching the surface "Ss" for dislodging particles "Ps" from the surface "Ss" and causing the particles "Ps" dislodged from the surface "Ss" to become airborne particles "Pa". For example, positioning of the focal point can be realized by an adjustable optic element enabling the focal point moving in height and/or in horizontal position over the surface. In another or further embodiment, the inspection system 100 comprises a particle detector 20 configured to detect the airborne particles "Pa" dislodged by the shockwave "W" from the surface "Ss". In some embodiments, the system 100 comprises a controller (not shown) to perform operational acts as described herein, e.g. control the lighting device 10, control and/or read out the particle detector 20, determine relative positioning, et cetera.

In some embodiments, the light beam "Lp" is configured to cause shockwave(s) "W" by generating a plasma in (clean) air or other (gaseous) medium above the surface "Ss". In one embodiment, a plasma is generated at a position where the power or intensity of the light beam is relatively high, e.g. above a threshold intensity. In another or further embodiment, a plasma causing the shockwave "W" is generated by light induced breakdown (LIB), e.g. of air or other medium, e.g. gas, above the substrate. For example, the light induced breakdown may cause a point explosion that generates at least one shockwave "W". Typically a plasma may be generated at light intensities greater than about 10¹² W/cm² in air at standard atmospheric conditions while this may be different in other in media/pressure.

In some embodiments, the light beam "Lp" comprises a (focused) laser beam. In other or further embodiments, the lighting device 10 comprises or couples to a light source such as a laser. In a preferred embodiment, the lighting device 10 comprises a pulsed light source, most preferably a pulsed laser source. High energy light pulses can also be generated by other light sources such as a (focused) beam originating from a flash lamp. Typically, the generation of the plasma and/or a force of the shockwave is configured or tuned by one or more of a power of the light beam, an energy of one or more light pulses forming the light beam, a pulse length of the one or more light pulses, a number of the light pulses used in sequence, and/or a size of a focus or focal volume formed by the light beam. For example, the focus may be determined by a numerical aperture of the lighting device, and/or wavelength of the light.

In some embodiments, the lighting device 10 comprises an optical system. In one embodiment, the optical system comprises optical components. For example, the optical system comprise one or more lenses and/or (curved) mirrors to guide and/or focus the light beam "Lp" at the focal point "Lf'. In another or further embodiment, the optical system comprises light guiding means such as an optical fiber. Also other or further components may be included as part of the optical system such as the light source configured to generate a light beam to be focused at the focal point "Lf".

One or more shockwaves may be used to dislodge the particles "Ps". For example, multiple shockwaves may be caused by focusing a sequence of multiple light pulses at a respective focal point "Lf'. In one embodiment, multiple light pulses are focused at the same focal point. In another or further embodiment, different light pulses are focused at different focal points, e.g. at different positions above the surface "Ss" and/or designated region "Rs" for inspection. In one embodiment, the system is configured to have the particle detector 20 measure, e.g. count, dislodged airborne particles "Pa" following a shockwave caused by a single light pulse from the lighting device 10. In another or further embodiment, the system is configured to have the particle detector 20 measure, e.g. count, dislodged airborne particles "Pa" following multiple shockwave caused by multiple light pulses from the lighting device 10 applied at a respective focal point "Lf' at the same position and/or at different positions above the designated region "Rs". In one embodiment, the focal point "Lf' is moved laterally with respect to the surface "Ss" (e.g. at a constant distance D) while measuring the resulting particles "Ps". For example, the focus is moved parallel along the surface "Ss". In another or further embodiment, the distance "Df' is varied while measuring the resulting particles "Ps". For example, if no particles are measured at a certain distance, the distance may be lowered until particles are measured and/or while the distance stays above a threshold which could otherwise damage the surface "Ss", e.g. substrate S.

In some embodiments, a lower distance "Df', higher energy, et cetera, may improve removal efficiency of particles, but may also increase chance of damaging the substrate. Preferably, the lighting device 10 is configured to generate the focused light beam at the focal point "Lf', e.g. the position where the waist diameter of the light beam "Lp" is minimal, at a distance "Df' from a designated region "Rs" on the surface "Ss", e.g. distance to the substrate surface. The distance "Df" is preferably between 0.1 and 5 mm, more preferably between 0.2 and 3 mm, most preferably between 0.5 and 1.5 mm.

While the present figures schematically illustrate a light beam "Lp" directed towards the surface "Ss", it will be understood that the light beam may be directed at an angle with respect to the surface normal. For example, an optical axis of the light beam "Lp" may be at an angle of more than forty-five degrees, preferably at an angle of more than eighty degrees, most preferably at an angle of (approximately) ninety degrees, e.g. parallel to the surface "Ss". By using a relatively large angle and/or beam more parallel to the surface, potential damage or heating of the surface by direct exposure may be alleviated.

As described herein, the particles "Ps" on the surface "Ss" may be relatively small. In some embodiments, the surface-bound particles "Ps" to be detected are microscopic particles, having a diameter less than one millimeter, e.g. between one and one hundred micrometer, or less. In other or further embodiments, the surface-bound particles "Ps" to be detected are nanoparticles which may have a diameter also less than one micrometer, e.g. between one and five hundred nanometer, typically between ten and two hundred nanometer. As will be appreciated, such nanoparticles may be difficult to measure using traditional techniques, yet may become increasingly problematic when they are present on the surface of a substrates such as wafers comprising circuit parts. Also other or further surfaces can be inspected such as a pellicle or mask. Accordingly, an advantageous application of the present methods and systems may include inspection of various surfaces in a lithographic method or system. In some embodiments, a lithography system comprises a wafer stage and/or mask stage configured to hold and/or position a wafer substrate "S" and/or mask; and the inspection system as described herein configured to inspect a surface "Ss" of the wafer substrate "S" and/or mask. Also other surfaces can be inspected for the presence of particles, e.g. mirrors, lenses, et cetera.

In some embodiments, an intensity of the shockwave(s) "W" is configured to dislodge surface-bound particles "Ps" that may be stuck or otherwise disposed on the surface "Ss". In one embodiment, the particles "Ps" dislodged from the surface "Ss" become airborne particles "Pa". In another or further embodiment, the dislodged or otherwise airborne particles "Pa" are introduced into a particle flow "Fp". For example, the particle flow "Fp" comprises a fluid medium, such as air or other gas, comprising at least some of the dislodged airborne particles "Pa". Airborne particles "Pa" will be understood as particles surrounded by air or other gas, as opposed to surface-bound particles "Ps". For example, the fluid medium (gas flow) carries the airborne particles away from the surface "Ss" in a particle flow "Fp".

In some embodiments, detecting particles "Pa" comprises detecting an amount "N" of particles, e.g. number of particles measured per unit of volume and/or time. In one embodiment, the particle detector 20 comprises a particle counter and/or flow meter. For example, particles may be continuously counted while a specific flow volume of a particle flow "Fp" passes by a sensor. In other or further embodiments, detecting particles "Pa" comprises detecting a size of the particles "Ps", e.g. measuring the size of detected particles and/or detecting only particles above a threshold size. In other or further embodiments, detecting particles "Pa" comprises detecting a type and/or composition of the particles "Ps", e.g. measuring the composition of detected particles and/or detecting only particles having one or more specific composition. For example, the type and/or composition of particles may be detected spectroscopically and/or by scattering properties of the particles. Also combinations are possible, e.g. determining an amount of particles with specific size, type, and/or composition, while ignoring or not measuring other particles.

In some embodiments, it may be determined that the surface "Ss" is (sufficiently) clean if the detected amount of particles "Ps" is below a threshold, or if no particles are detected. For example, a determination that the surface "Ss" is clean may be used as a prerequisite for performing an operation on the substrate such as a (first or further) processing step, e.g. applying one or more layers, circuit parts, and/or components. In other or further embodiments, it may be determined that the surface "Ss" is contaminated if the detected amount of particles "Ps" is above a threshold, or if particles above a certain size are detected, or even if any particles are detected at all. For example, a determination that the surface "Ss" is contaminated may trigger a (first or further) cleaning operation on the substrate and/or clean room, or cause the substrate to be discarded.

Preferably, the gaseous medium (e.g. air) above the surface "Ss" is substantially clean, i.e. with minimal or no airborne particles "Pa", prior to performing an inspection. For example, the gaseous medium conforms with a clean room classification (e.g. ISO 14644-1 Cleanroom Standards) equal to or better than ISO 5, preferably ISO 4, more preferably ISO 3, more preferably ISO 2, most preferably ISO 1. The cleaner the initial conditions, the more easily airborne particles "Pa" measured after the application of one or more shockwaves can be distinguished. Alternatively, or additionally, to distinguish airborne particles "Pa" originating the surface "Ss" caused by dislodging the surface bound particles "Pa" from airborne particles which do not originate from the surface "Ss" (i.e. present before the shockwave), some embodiments may include performing a base measurement, e.g. before applying the shockwave "W".

In some embodiments, the inspection system 100 is configured to perform a measurement sequence. In one embodiment, the measurement sequence comprises a first measurement of any airborne particles detected by the particle detector 20 prior to applying the shockwave "W" by the lighting device 10. In another or further embodiment, the measurement sequence comprises a second measurement of any airborne particles detected after applying the shockwave "W" by the lighting device 10. In another or further embodiment, a contamination and/or cleanliness of the surface "Ss" is determined, e.g. quantified, by comparing the second measurement with the first measurement. For example, if the second measurement does not yield substantially different results than the first measurement (below a threshold difference), this may be an indication that the surface "Ss" is (sufficiently clean). For example, if the second measurement yields detection of substantially more particles than the first measurement (above a threshold difference), this may be an indication that the surface "Ss" is contaminated.

In some embodiments, the inspection system 100 may wait until initial conditions are suitable for performing an inspection of a surface "Ss". For example, the system may wait initially and/or between different measurements until the number of airborne particles is below a threshold. In one embodiment, the inspection system 100 is configured to apply the shockwave(s) "W" depending on a result of the first measurement. In another or further embodiment, the inspection system 100 is configured to (continuously or intermittently) perform the first measurement prior to applying the shockwave "W" until the first measurement detects airborne particles below a threshold number (e.g. number of particles per unit volume and/or per unit time measured), wherein the shockwave "W" is applied after determining the airborne particles in the first measurement are below the threshold number, and the second measurement of the airborne particles "Pa" is performed after the shockwave "W" is applied.

In some embodiments, the airborne particles "Pa" are measured while traveling along with a particle flow "Fp". In other or further embodiments, the particle flow "Fp" is configured to carry at least some of the particles "Ps" to a particle detector 20. In one embodiment, the particle detector 20 is configured to receive a particle flow "Fp" comprising (at least some of) the dislodged airborne particles "Pa" and detect the airborne particles "Ps" in the particle flow "Fp". In another or further embodiment, the particle detector 20 comprises a channel 20c configured to carry the particle flow "Fp" to a particle sensor (not shown here). In some embodiments, the inspection system 100 is configured to establish a particle flow "Fp" by sucking and/or blowing air or other gaseous medium into and/or though the channel 20c of the particle detector 20. For example, the particle detector 20 comprises a pump to suck air from above the surface "Ss" and/or designated region "Rs" and/or focal point "Lf". Alternatively, or additionally (clean) air or other gaseous medium can be supplied to the designated region "Rs" and/or focal point "Lf' which is blown into the channel 20c.

Preferably, the particle detector 20 is configured to detect the airborne particles "Pa" in the particle flow "Fp", e.g. carried by a fluid medium through a detection channel 20c. It will be understood that the particle flow "Fp" carried to the particle detector 20 does not need to contain all dislodged airborne particles "Pa" for carrying out an inspection, e.g. measurement, representing the presence and/or (relative) quantity of particles "Ps" which are (or were) disposed on the surface "Ss" and/or designated region "Rs". In some embodiments, the particle flow "Fp" in which the particles "Ps" are detected, comprises at least 10% of the dislodged airborne particles "Pa", preferably at least 20%, more preferably at least 50%, most preferably at least 90%, or substantially all of the dislodged airborne particles "Pa".

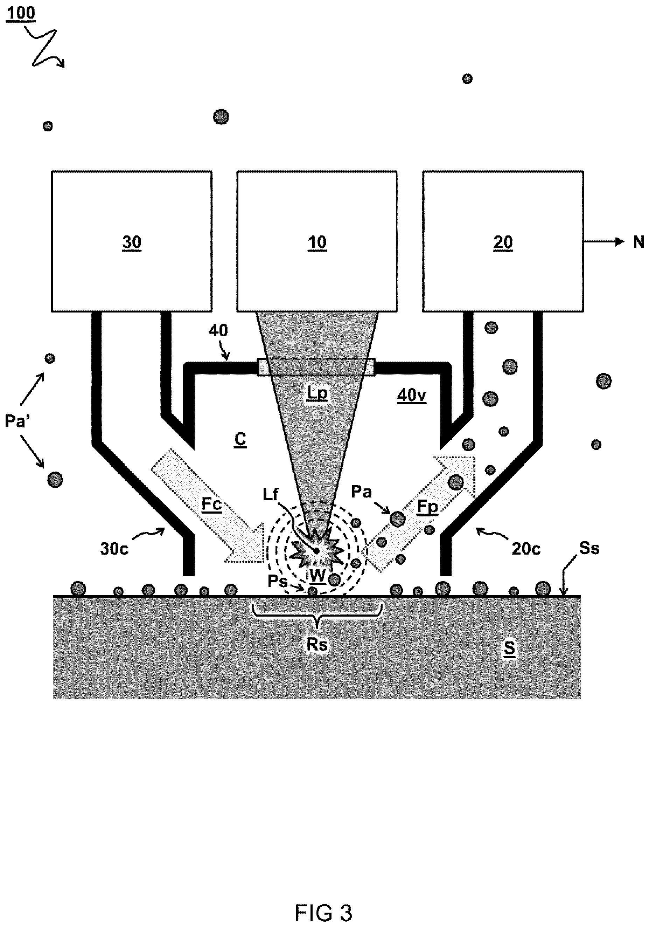

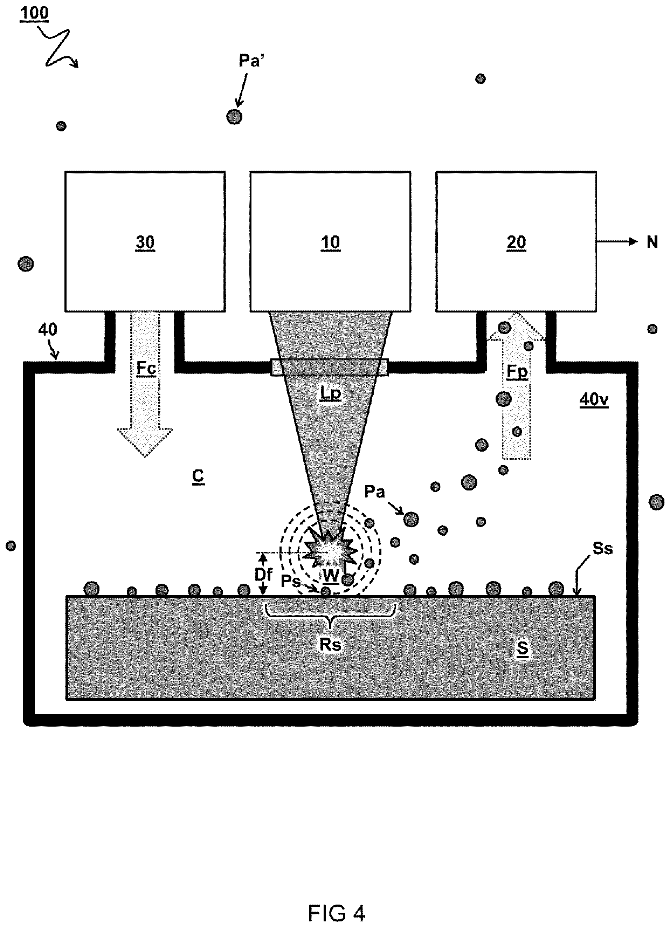

In some embodiments, the particle detector 20 comprises, or is fluidly coupled to, a flow inlet 20i adjacent the focal point "Lf' of the lighting device 10 and/or adjacent the designated region "Rs" (which is practically very close). For example, the flow inlet is formed by an entry into a channel 20c carrying the particle flow "Fp" to, or along, an airborne particle sensor. For example, the flow inlet 20i is arranged at a distance of less than ten centimeter from the focal point "Lf', preferably at a distance of less than five centimeter, more preferably at a distance of less than one centimeter, most preferably at a distance of less than half a centimeter, or even less, e.g. as close as possible. The closer the flow inlet 20i is arranged with respect to the focal point "Lf' and/or designated region "Rs" on the surface "Ss", the more likely the dislodged particles may enter the flow inlet 20i. Alternatively, the flow inlet may be further away, e.g. by establishing a closed configuration around a designated region "Rs" or the surface "Ss" as shown in FIG 3, and/or containing the entire surface "Ss" and/or substrate "S" as shown in FIG 4.

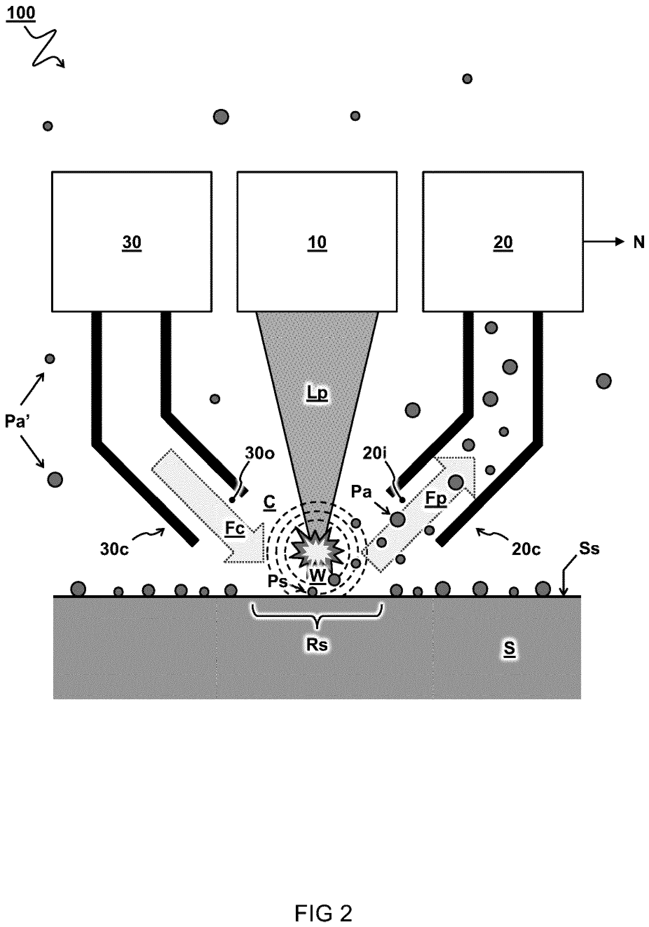

FIG 2 illustrates aspects of an inspection system 100 further comprising a flow source 30. In some embodiments, the flow source 30 is configured to provide a gas flow "Fc" of source gas into a volume adjacent (e.g. directed towards and/or along) the designated region "Rs" and/or the focal point "Lf". In one embodiment, a particle flow "Fp" towards the particle detector 20 is established comprising (at least some of) the dislodged airborne particles "Pa" carried in a flow of the source gas from the flow source 30.

Preferably, the source gas from the flow source is relatively clean, e.g. having a relatively low concentration of airborne particles. For example, the source gas has a concentration of airborne particles that is less than the concentration of airborne particles "Pa"' of a surrounding volume further away from the focal point "Lf" and/or designated region "Rs". For example, the source gas conforms with one of the preferred clean room classifications as mentioned above. Since a substantial portion of the particle flow "Fp" may be formed by the relatively clean source gas, the preferred clean room classification of the further surroundings may be less stringent, e.g. there may be more stray particles "Pa'".

In one embodiment, the flow source 30 comprises or couples to a container of clean gas, e.g. Nitrogen gas and/or Helium gas. For example, the clean gas is supplied to the designated region "Rs" of the surface "Ss" from a pressurized container. Alternatively, or additionally, the source gas may be provided by evaporating a liquid, e.g. from a liquid Nitrogen container. In another or further embodiment, the gas flow "Fc" of source gas is cleaned before being supplied to the designated region "Rs". For example, the flow source 30 comprises a particle filter. In another or further embodiment, the flow source 30 comprises a pump to provide a gas flow "Fc" of source gas, e.g. from the container and/or through the particle filter.

In some embodiments, the flow source 30 comprises, or is fluidly coupled to, a flow outlet 30o adjacent the focal point "Lf" of the lighting device 10 and/or adjacent the designated region "Rs" (which is practically very close). For example, the flow outlet is formed by an exhaust from a channel 30c carrying the source gas into the designated region "Rs". For relatively small particles sizes, the flow speed may be limited, e.g. (much) less than 1 cm/s. In case of larger particles (e.g. > 5 micron) higher flow speeds may be used, e.g. > 1 cm/s, more preferably > 5 cm/s. For example, the flow outlet 30o is arranged at a distance of less than ten centimeter from the focal point "Lf", preferably at a distance of less than five centimeter, more preferably at a distance of less than one centimeter, most preferably at a distance of less than half a centimeter, or even less, e.g. as close as possible. The closer the flow outlet 30o is arranged with respect to the focal point "Lf" and/or designated region "Rs" on the surface "Ss", the easier it may be to control the local atmosphere, e.g. establish a relatively clean environment without particles before applying the shockwave(s). Alternatively, the flow inlet 20i may be further away, e.g. by establishing a closed configuration around a designated region "Rs" or the surface "Ss" as shown in FIG 3, and/or containing the entire surface "Ss" and/or substrate "S" as shown in FIG 4. In some embodiments, the system may wait until the initial conditions are suitable for performing an inspection of the substrate. For example, the system may supply clean source gas and/or wait until the number of airborne particles is below a threshold before applying the shockwave(s) "W".

FIG 3 illustrates an inspection system 100 further comprising a container 40 with an opening placed against the surface "Ss". In some embodiments, the system comprises a container 40 encapsulating a contained volume 40v which includes the focal point "Lf' above a designated region "Rs" of the surface "Ss", wherein the particle detector 20 comprises a channel 20c connected to receive the airborne particles "Pa", e.g. particle flow "Fp", from the encapsulated volume 40v.

Preferably, the system comprises a flow source 30 configured to provide a gas flow "Fc" of (clean) source gas into the contained volume 40v. By supplying clean air into the contained volume 40v, prior to, or between, applying one or more shockwave "W", measurement sensitivity may be improved by reducing background particles "Pa"' which may have been present before applying the shockwave "W". Furthermore, a pressure of the clean gas being supplied to the contained volume 40v may push a particle flow "Fp" into the channel of the particle detector 20. Alternatively, clean air could be sucked from the environment if the flow source is omitted. For example, the contained volume 40v may have a small opening to suck environmental air.

In some embodiments, e.g. as shown, the container 40 is formed by a cup shaped probed head ("cup") having an opening for placement over a designated region "Rs" of the surface "Ss". For example, the (upside-down) cup has a circumferential sidewall, is closed from one side (here the top), and open on the other side (here the bottom). Preferably, the cup can form an essentially contained volume 40v by contacting the surface "Ss" around the designated region "Rs". To improve sealing, the cup may be provided with a flexible material such as rubber around a rim of the cup, e.g. forming O-ring. To more easily establish a clean base environment, the cup (when the opening is closed off by a flat surface) may have a relatively small volume, e.g. less than one liter (≤ 1 dm³), preferably less than one hundred cubic centimeter, more preferably less than twenty cubic centimeter, e.g. between one and ten cubic centimeter, or less. The smaller the contained volume 40v, the more easy it may be to remove initial airborne particles "Pa" before starting shockwave(s) "W" to determine surface bound particles "Ps". Typically, a volume under the movable cup may be pre-flushed with at least ten times the volume of the cup to reach a significant lower particle concentration. Alternatively to contacting the surface "Ss", the rim of the cup may hover at a small distance above the surface, e.g. at a distance of less than one centimeter, preferably less than half a centimeter, or even less than one millimeter. For example, the surface "Ss" may be sensitive to damage and by hovering the cup a small distance above the surface "Ss" such damage may be alleviated while still providing an essentially contained volume. By providing an overpressure inside the cup, it can anyway be prevented that environmental airborne particles "Pa"' can enter the contained volume 40v.

In some embodiments, the focal point "Lf' if the lighting device 10 is configured relative to the rim of the cup. For example, the focal point "Lf' is established at a preferred distance "Df', as noted earlier, with respect to a plane spanned by the rim of the cup. In other or further embodiments, the inspection system 100 comprises a sensor (not shown here) configured to detect a position of the surface "Ss" and adjust the position of the focal point "Lf' in accordance with a preferred distance "Df'. In other or further embodiments, a position of the surface "Ss" can be derived, e.g. by the position of a substrate carrier. In other or further embodiments, a position of the surface "Ss" can be assumed and/or a fixed focal point "Lf' can be used, e.g. when using a substrate with known thickness, position, et cetera.

FIG 4 illustrates an inspection system 100 comprising a container 40 holding a substrate inside. In some embodiments, the system 100 comprises a container 40, e.g. box, encapsulating a contained volume 40v configured to hold a substrate "S" inside, and inspect a surface "Ss" of the substrate "S" in the contained volume 40v. In one embodiment, e.g. as shown, a flow inlet of the particle detector 20 is connected to the container 40 to receive a particle flow "Fp" from the contained volume 40v. In another or further embodiment (not shown), the particle detector 20 is partly or fully contained inside the container 40, preferably having an exhaust outside the container (e.g. after measuring the particle flow "Fp"). In another or further embodiment, e.g. as shown, a flow outlet of a flow source 30 is connected to the container 40 to receive a gas flow "Fc" of (clean) source gas into the contained volume 40v. Depending on the size of the contained volume 40v, typically a gas flow between one and hundred liter per minute may be used, preferably between ten and fifty liter per minute. When the contained volume 40v is relatively small, e.g. like in FIG 3, a relatively small gas flow may be sufficient. A pressurized gas supply or other flow source 30 could also be contained inside the container 40.

In some embodiments, it may be advantageous to increase a pressure inside the contained volume 40v, e.g. above atmospheric pressure, by supplying more gas via the flow source 30 and/or other supply channel. For example, a higher pressure environment may increase a peak pressure of the shockwave "W" and thereby improve efficiency. In other embodiments, it may be advantageous to lower a pressure inside the contained volume 40v, e.g. below atmospheric pressure, by sucking out more air via the particle detector 20 and/or other suction channel. For example, a lower pressure environment may lower a peak pressure of the shockwave "W" and thereby alleviate damage to the surface "Ss".

In some embodiments, e.g. as shown, the lighting device 10 is outside the container 40. For example, the container 40 comprises a window to pass the light beam "Lp" inside the container. Alternatively, or in addition to a window, the container 40 may comprise at least part of an optical system configured to focus the light beam "Lp". For example, the window can be replaced with a lens (not shown here) configured to receive a collimated or otherwise unfocused light beam. The window or lens can also be connected to a light guide as shown in the next figure.

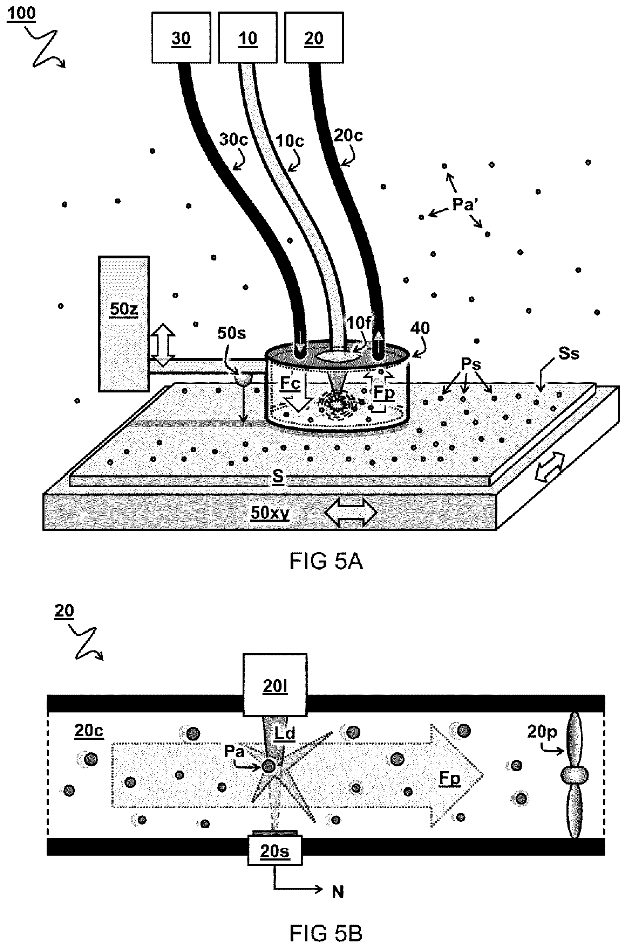

FIG 5A illustrates further aspects of an inspection system 100. In some embodiments, the system comprises a cup shaped probe head ("cup) forming a container 40 and/or contained volume 40v when it is placed against, or provided close to, the surface "Ss" to be inspected. For example, the cup described here with reference to FIG 5 may have similar or the same properties as described above with reference to FIG 3, and vice versa. In one embodiment, the cup is connected by a light guide 10c, e.g. optical fiber, to receive the light beam "Lp" focused at the focal point "Lf' inside the cup, e.g. near a plane established by a rim of the cup. In another or further embodiment, the cup is fluidly connected by a first hose forming a first channel 20c to guide a particle flow "Fp" from the contained volume 40v towards the particle detector 20. In another or further embodiment, the cup is fluidly connected by a second hose forming a second channel 20c to guide a gas flow "Fc" of source gas from a flow source 30 into the contained volume 40v. Preferably, each of the light guide and respective one or more hoses are flexible so the cup can be moved relatively freely with respect to the surface "Ss".

In some embodiments, the cup is configured for manual placement on a surface "Ss" to be inspected. In other or further embodiments, the cup is configured for automatic placement and/or (re)positioning with respect to the surface "Ss". In some embodiments, the position of the cup relative to the surface "Ss" is determined by one or more actuators. For example, the cup is held by an actuator 50z configured to determine a distance relative to the surface "Ss". For example, the surface "Ss" is part of a substrate held by a moveable stage 50xy to determine the location of the cup along the surface. Of course, also other or further actuators can be used to determine the relative positions. For example, the actuator 50z may alternatively, or additionally include XY positioning. For example, the stage 50xy may alternatively, or additionally include Z positioning. Optionally, the relative position of the surface "Ss" with respect to the cup may be determined by a sensor 50s. Alternatively, or additionally, the position of the surface "Ss" can be determined by a contact surface, e.g. the rim of the cup. Positioning actuators of the surface "Ss" with respect to the focal point "Lf" can also be provided for other embodiments, e.g. any of FIGs 1 - 4, optionally in combination with a sensor arrangement to detect the relative or absolute positions of the surface "Ss", optical system determining the focal point "Lf", flow inlet 20i, flow outlet 30o, et cetera. The relative positions may also be adjustable based on the measured particles. Also combinations of features described with reference to different embodiments can be envisaged. For example, the cup shaped probe head as shown in FIG 3 or 5A can be encapsulated in a container as shown in FIG 4.

FIG 5B illustrates further aspects of a particle detector 20. In some embodiments, e.g. as shown, detecting particles "Pa" comprises counting or otherwise detecting airborne particles which pass with a particle flow "Fp" through a detection beam "Ld". In one embodiment, the particle detector 20 comprises a channel 20c receiving a particle flow "Fp". In another or further embodiment, the particle detector 20 comprises a light source 201 configured to emit a sensor beam "Ld" into the channel 20c. In another or further embodiment, the particle detector 20 comprises a particle sensor 20s configured to detect the sensor beam "Ld". For example, interruption or scattering of the sensor beam "Ld" by passing airborne particles "Pa" may be detected as a lowering of light intensity and/or other positional deviation of the beam on the particle sensor 20s. In this way particles passing the sensor beam "Ld" may be counted, e.g. as dips in the sensor signal. Also other or further properties can be measured, e.g. a size and/or composition of the particles. In some embodiments, the particle detector 20 comprises or couples to a pump 20p, preferably sucking air out from the channel 20c downstream of the particle sensor 20s. For example, the pump comprises a fan or other means for sucking and/or blowing the particle flow "Fp" through the channel 20c. In other or further embodiments, air may be pushed into the channel 20c by overpressure e.g. in a container 40 supplied with source gas.

In principle, any known or yet to be discovered technique can be used for providing a light induced shockwave "W" and/or detecting the (airborne) particles "Pa". For example, a condensation particle counter (CPC) can be used for detecting relatively small particles. Also other types of airborne particle detection can be used such as electrostatic techniques. For example, in some embodiments, (not shown), detecting particles "Pa" comprises detecting particles depositing onto a sensor surface or filter, e.g. detecting the presence and/or amount of deposited particles. Also other or further ways of detecting particles "Pa" in a particle flow "Fp" can be envisaged.

In interpreting the appended claims, it should be understood that the word "comprising" does not exclude the presence of other elements or acts than those listed in a given claim; the word "a" or "an" preceding an element does not exclude the presence of a plurality of such elements; any reference signs in the claims do not limit their scope; several "means" may be represented by the same or different item(s) or implemented structure or function; any of the disclosed devices or portions thereof may be combined together or separated into further portions unless specifically stated otherwise.

## Claims

1. A method for inspecting a surface (Ss), the method comprising
providing a light beam (Lp) focused at a focal point (Lf) at a distance (Df) from the surface (Ss) to cause a shockwave (W) reaching the surface (Ss) for dislodging particles (Ps) from the surface (Ss) and causing the particles (Ps) dislodged from the surface (Ss) to become airborne particles (Pa); and
detecting the airborne particles (Pa) dislodged by the shockwave (W) from the surface (Ss).

2. The method according to the preceding claim, comprising quantifying a cleanliness and/or contamination of the surface (Ss) by surface-bound particles (Ps), which were at least present on the surface (Ss) prior to the shockwave (W), based on a detected amount of the airborne particles (Pa), after the shockwave (W).

3. The method according to any of the preceding claims, wherein the detected airborne particles (Pa) dislodged by the shockwave (W) from the surface (Ss) comprise nanoparticles having a diameter between one and two hundred nanometer.

4. A system (100) for inspecting a surface (Ss), the system (100) comprising
a lighting device (10) configured to provide a light beam (Lp) focused at a focal point (Lf) at a distance (Df) from the surface (Ss) to cause a shockwave (W) reaching the surface (Ss) for dislodging particles (Ps) from the surface (Ss) and causing the particles (Ps) dislodged from the surface (Ss) to become airborne particles (Pa); and
a particle detector (20) configured to detect the airborne particles (Pa) dislodged by the shockwave (W) from the surface (Ss).

5. The system (100) according to the preceding claim, wherein the particle detector (20) comprises a channel (20c) configured to receive a particle flow (Fp) comprising the dislodged airborne particles (Pa) and detect the airborne particles (Ps) in the particle flow (Fp).

6. The system (100) according to the preceding claim, wherein the channel (20c) has a flow inlet (20i), to receive the particle flow (Fp), within a distance of less than ten centimeter from the focal point (Lf) provided by the lighting device (10).

7. The system (100) according to any of the two preceding claims, comprising a flow source (30) configured to provide a gas flow (Fc) of source gas into a volume (40v) comprising the focal point (Lf), wherein the channel (20c) of the flow inlet (20i) is configured to receive the particle flow (Fp) comprising the dislodged airborne particles (Pa) carried in a flow of the source gas from the flow source (30).

8. The system (100) according to the preceding claim, wherein the flow source (30) has a flow outlet (30o) for the gas flow (Fc) of source gas within a distance of less than ten centimeter from the focal point (Lf) of the lighting device (10).

9. The system according to any of the preceding claims, comprising a probe head shaped as a cup configured to form a contained volume (40v) when placed against the surface (Ss) to be inspected,
wherein the probe head is connected by a light guide (10c) to receive the light beam (Lp) focused at the focal point (Lf) inside the cup, in particular at the distance (Df) from a plane established by a rim of the cup, the plane corresponding to a designated region (Rs) of the surface (Ss) to be inspected;
wherein the probe head is fluidly connected by a first hose forming a first channel (20c) to guide a particle flow (Fp) from the contained volume (40v) towards the particle detector (20); and
wherein the probe head is fluidly connected by a second hose forming a second channel (20c) to guide a gas flow (Fc) of clean source gas, without the particles, from a flow source (30) into the contained volume (40v);

10. The system (100) according to the preceding claim, wherein each of the light guide and respective hoses are flexible so the probe head can be freely moved to different regions (Rs) of the surface (Ss).

11. The system (100) according to any of the preceding claims, comprising a container (40) encapsulating a contained volume (40v) configured to hold a substrate (S) inside; wherein the system (100) is configured to inspect the surface (Ss) of the substrate (S) in the contained volume (40v), wherein the particle detector (20) comprises a channel (20c) connected to receive the airborne particles (Pa) from the contained volume (40v), wherein a flow source (30) is configured to provide a gas flow (Fc) of clean source gas, without particles, into the contained volume (40v).

12. The system according to any of the preceding claims comprising a controller configured to perform a measurement sequence comprising
a first measurement of any airborne particles detected by the particle detector (20) prior to applying the shockwave (W) by the lighting device (10); and
a second measurement of any airborne particles detected after applying the shockwave (W) by the lighting device (10);
a quantification of a contamination and/or cleanliness of the surface (Ss), determined by comparing the second measurement with the first measurement.

13. The system according to any of the preceding claims comprising a controller configured to
perform a first measurement of any airborne particles detected by the particle detector (20) prior to applying the shockwave (W) until the first measurement detects an amount of airborne particles below a threshold,
control the lighting device (10) to apply the shockwave (W) after determining the airborne particles in the first measurement are below the threshold number,
perform a second measurement of the airborne particles (Pa) by the particle detector (20) is performed after the shockwave (W) is applied.

14. The system (100) according to any of the preceding claims, comprising a sensor (50s) or contact surface, e.g. of a probe head, configured to determine a position of a designated region (Rs) on the surface (Ss), wherein the lighting device (10) is configured to focus the light beam (Lp) to generate a plasma at the focal point (Lf) at a distance (Df) between 0.1 and 5 mm from the determined position of the designated region (Rs).

15. A lithography system comprising
a wafer stage and/or mask stage configured to hold and/or position a wafer substrate (S) and/or mask; and
the system (100) for inspecting a surface (Ss) according to any of the preceding claims, configured to inspect a surface of the wafer substrate (S) and/or mask.
